# EUROPEAN PATENT APPLICATION

(11) **EP 0 632 457 A1**
(43) Date of publication of application: **04.01.1995**
(21) Application number: 94304672.2
(22) Date of filing: 27.06.1994
(51) Int. Cl.: G11C 7/00

(54) **Method and system for providing data hold time by synchronous random access memory during write operations**

(30) Priority: 01.07.1993 US 85993
(71) Applicant: TANDEM COMPUTERS INCORPORATED, Cupertino, California 95014 (US)
(72) Inventor: Dan, Yei-Fong, Cupertino, California 95014 (US)
(74) Representative: Ayers, Martyn Lewis Stanley

(57) **Abstract**

A memory interface on a semiconductor integrated circuit that is used to write data to an external memory upon the clocking of a write strobe signal and that requires data be held valid for a brief time period after the write strobe signal is deasserted. The memory interface enables and disables the semiconductor IC from transferring data to a data bus connected to the external memory upon the assertion and deassertion of the write strobe signal. Data is kept stable on the data bus while the write strobe signal is asserted and allowed to become unstable only after the write strobe signal is deasserted.

## Description

The present invention relates generally to an interface on a semiconductor integrated circuit (IC) to write and read data to an external memory. More specifically, the present invention relates to a memory interface on a semiconductor IC that transfers data to a data bus and writes the data to an external memory upon the clocking of a write strobe signal. The memory interface enables and disables the semiconductor IC from transferring data to the data bus upon the assertion and deassertion of the write strobe signal.

Semiconductor devices commonly use a memory interface circuit to communicate and transfer data to an external memory such as static random access memory (SRAM). The memory interface circuit generally sends several control signals along with address and data information to the external memory to ensure that the transfer operation is successful. The control signals are used to time the transfer operation in an appropriate manner according to requirements of the external memory. The control signals typically include an output enable signal that indicates the direction of data transference, i.e., from the memory to the computer or from the computer to the memory, and a write strobe signal that clocks data being transferred to the memory.

To write data to the external memory, the memory interface sets the output enable signal to indicate that a write operation will take place and an address is placed on an address bus to indicate the address in the memory to which that data will be written. The memory interface then grabs and places data on the data bus, and the write strobe signal is clocked to initiate the write operation. After the write operation is completed, the bus is released and the memory interface is readied to perform another operation.

Most SRAMs have strict timing requirements for the write cycle to be successful. One of these requirements deals directly with how long data on the data bus must remain stable (data becomes unstable once the bus is released) after the write strobe signal is deasserted. The time data must remain stable is commonly referred to as the minimum data "hold" time. Typically, the data hold time is from one to five nanoseconds, but some chips have a zero hold time. Memory chips having a zero hold time, however, usually require that the data remain stable until at least the instant the write strobe signal is deasserted. In other words, for write operations to be successful on these chips, the data bus cannot be released by the memory interface before the write strobe signal is deasserted.

Thus, when designing semiconductor circuits that interface with external memories such as application specific integrated circuits (ASICs), designers must ensure that data is kept on the data bus for either a fixed time period after the write strobe signal is deasserted or until at least the instant the write strobe signal is deasserted, depending on the external memory used. To achieve an optimally functioning system, i.e., peak performance, data should be held stable just long enough to meet the external memory's timing requirements and not an instant longer. If not enough time is allowed to keep the data stable, errors will occur in the write operation resulting in loss of data and unpredictable results. On the other hand, if data is kept stable for an excessive period of time after the write strobe signal is deasserted, less time is available for other computing tasks and performance will suffer.

Several methods have been available to designers to ensure that this minimum data hold time requirement is met. One method involves placing data on the data bus at different clock cycles or different clock phases. For example, using different clock cycles would entail asserting the write strobe signal on a first clock cycle and waiting until the next clock cycle to place data on the data bus. Using different clock phases would entail asserting the write strobe on one edge of a clock signal, e.g., the rising positive edge, and placing data on the data bus at the other edge, e.g., the falling negative edge. Both of these methods suffer from inefficient operation because valuable processing time is lost in waiting for either the next clock cycle or next clock edge. Generally, the performance loss resulting from the use of different clock cycles or different clock edges to guarantee that data is kept on the data bus for the minimum hold time is unacceptable to designers of ASIC designs, and thus, the method is seldomly used.

Another method designers can use to guarantee a minimum data hold time is to add delay lines to the data lines. Delay lines are external delay gates coupled to the data bus and thus placed in the path of the data transfer. This scheme is expensive to implement in terms of board space and in hardware costs and is not practical when there are more than two or three data paths that need delay lines.

Finally, designers can use internal gates to delay data on the data path by a fixed period of time. This is the most common solution used today, but there are several difficulties involved with adding internal delay gates to a circuit that make this method less than optimal. It is extremely difficult to determine what length of time delay needs to be added to the data path to always ensure that the minimum data hold time is met.

One factor that contributes to the problem of determining the time delay is the propagation delay introduced to the write strobe and data signals by the capacitance and trace length differences of the external memory or load coupled to the memory interface. The propagation delay associated with the write strobe signal is usually greater than the propagation delay associated with the data signal on the data bus because there is usually more of a load on the write strobe signal than on the data signal. The-strobe line must go to all external memory chips associated with the circuit, while the data line often only needs to go to a subset of the external memory chips. The extra delay on the write strobe signal varies greatly depending on factors such as how many more external memory chips it must propagate through than the data line and capacitance associated with each memory chip.

Another factor that contributes to the problem of determining the time delay is the internal clock skew that exists on circuits. The clock skew may be relatively small compared to the delays associated with the load, but if the skew is not accounted for in the design of a circuit, the clock skew of the write strobe line may cause the data line to change before the deassertion of the write strobe line.

To ensure proper operation of the write cycle at all times, a designer using the fixed, internal delay approach must include a large enough delay to account for the worst case. Once this delay is calculated (or obtained by making an educated best guess), gates with the appropriate delay are incorporated into the data path. The variance in a gate's delay from best case to worst case, however, is typically around one to three. Thus, if a designer calculates that a ten nanosecond delay is necessary to ensure successful write operations, gates with a minimum time delay of ten nanoseconds must be added to the data path. Because the maximum delay of those gates is likely to be three or more times greater than the minimum delay, a delay of thirty nanoseconds or more may actually be placed into the data path. The thirty nanosecond delay is unacceptable in performance terms for many applications.

The present invention solves the problems associated with the prior art by providing a memory interface for ASIC or non-ASIC circuits that guarantees the data hold time is always sufficient for a data write operation and that also ensures performance will be optimized by not allowing the data hold time to be too long.

The present invention accomplishes this by using a feedback means to disable the writing of data from the memory interface to the data bus on the deassertion of the write strobe signal sent to an external memory. One aspect of the present invention comprises a writing means, having an input to accept a control signal to enable and disable the writing means, that places data on a transmission channel so that the data can be written to an external memory; a reading means for reading data placed on the transmission channel by the memory unit; a write strobe gate that receives an internal write strobe signal and outputs an external write strobe signal; and a disabling means for disabling and enabling the writing means by producing the control signal by delaying the external write strobe signal for a fixed time period.

A method of providing a minimum data hold time for a memory during a write operation is also disclosed. The method comprises the steps of: asserting an external write strobe signal to initiate the write operation; enabling a data write gate to output data to a data bus; deasserting the external write strobe signal; and disabling the data write gate upon the deassertion of the external write strobe signal so that the data write gate is disconnected from the data bus.

The features and advantages of a memory interface according to the present invention will be more clearly understood from the following description taken in conjunction with the accompanying drawings.
Fig. 1 is a block diagram illustrating the interfacing of an integrated circuit with an external memory;
Fig. 2 is a schematic diagram of the memory interface unit shown in Fig. 1 according to one embodiment of the present invention;
Fig. 3 is a timing diagram depicting the timing of a write cycle when data is written to an external memory from the memory interface unit shown in Fig. 1;
Fig. 4 is a block diagram showing how the memory interface unit of Fig. 2 can be used to automatically adjust for timing delays inherent when multiple memories are coupled to the write strobe line;
Fig. 5 is a schematic diagram of the memory interface unit shown in Fig. 1 according to a second embodiment of the present invention; and
Fig. 6 is a timing diagram that depicts the timing of a write cycle when data is written to an external memory from the memory interface unit depicted in Fig. 5.

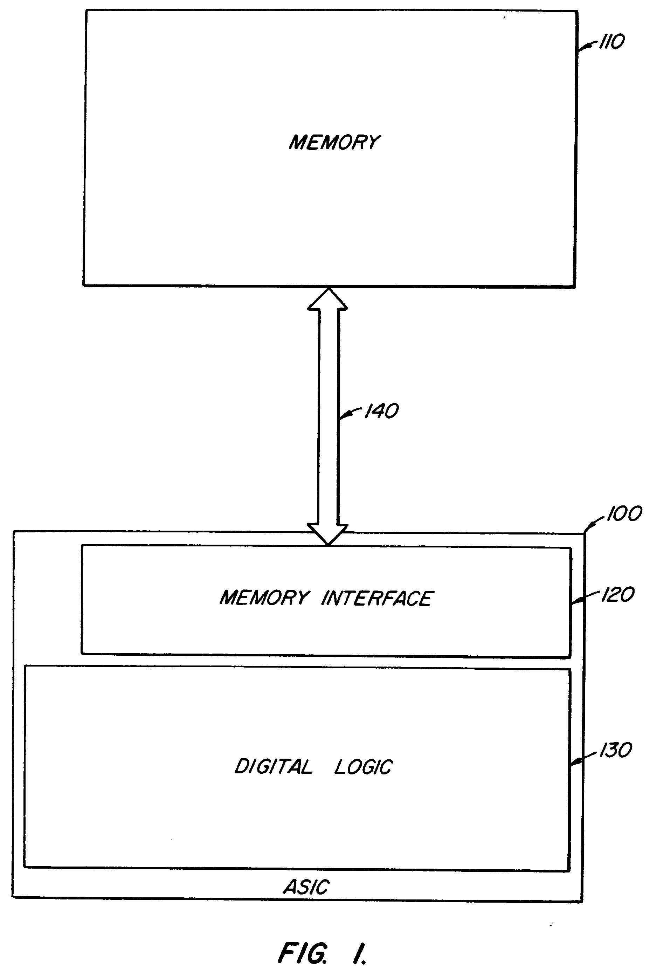

Fig. 1 is a block diagram illustrating the interfacing of an integrated circuit 100 with an external memory 110. Integrated circuit 100 can be an application specific integrated circuit (ASIC) or any other integrated circuit that reads data from and writes data to an external memory. Integrated circuit 100 comprises memory interface unit 120 and digital logic 130. Memory interface unit 120 communicates with digital logic 130 over communication paths internal to integrated circuit 100 and not shown in Fig. 1. Digital logic 130 is a combination of logic gates and circuit elements that perform specified functions. The functions performed by digital logic 130 can be of almost unlimited scope, but typically digital logic 130 performs application specific input and output functions.

Memory interface unit 120 is coupled to and communicates with external memory 110 through bus 140. Bus 140 is used by memory interface unit 120 to carry necessary control and data signals to read data from external memory 110 and write data to external memory 110 when indicated to do so by digital logic 130.

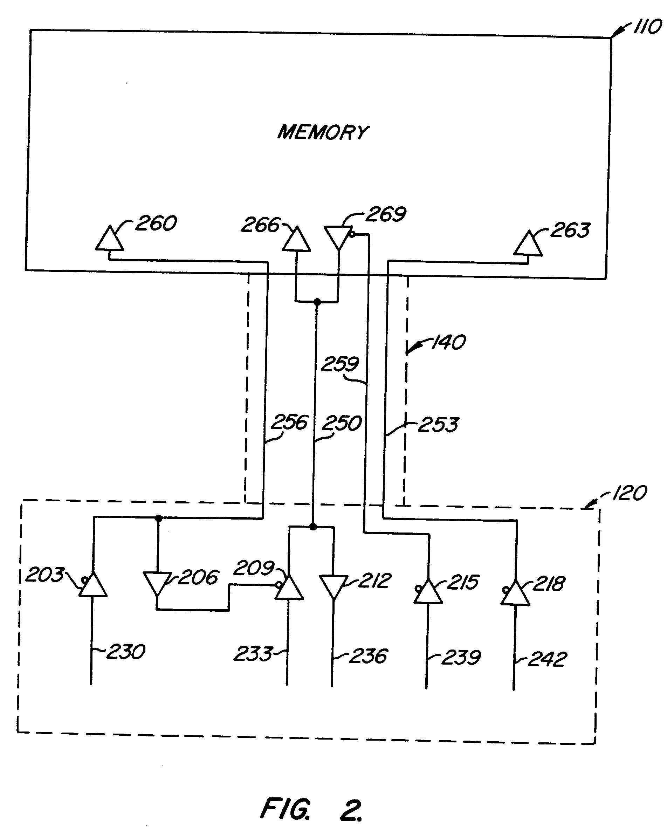

Fig. 2 is a schematic diagram of memory interface unit 120 shown in Fig. 1 according to one embodiment of the present invention. For convenience, the same reference numerals used in Fig. 1 are used in Fig. 2 to refer to like elements. Memory interface unit 120 comprises a write strobe gate 203, a feedback gate 206, a data write gate 209, a data read gate 212, an output enable gate 215, and an address gate 218.

Memory interface unit 120 receives communication control and data signals from digital logic 130 over communication paths 230, 233, 236, 239, and 242 to control the transfer of data between memory interface unit 120 and external memory 110. Communication path 230 carries an internal write strobe signal that times the writing of data from memory interface 120 to external memory 110. Communication path 233 carries a data output signal that carries N-bits of data from memory interface unit 120 to external memory 110 during a data write operation. Communication path 236 carries a data input signal that carries N-bits of data received by memory interface unit 120 from external memory 110 to digital logic 130 during a data read operation. Communication path 239 carries an output enable signal, which indicates to external memory 110 whether a read or write operation is to take place. Communication path 242 carries an address signal, which indicates the address in external memory 110 that will be written to or read from.

Information necessary for the exchange of data between memory interface unit 120 and external memory 110 travels over bus 140. Bus 140 comprises an N-bit data bus 250, an address bus 253, a write strobe line 256, and an output enable line 259.

External memory 110 comprises signal receiving gates 260 and 263, which are coupled to write strobe line 256 and address bus 253, respectively, and data input gate 266 and data output gate 269, which make up a bi-directional input/output gate and are coupled to data bus 250. Data output gate 269 is a tri-state device that is coupled at an enabling/disabling input to output enable line 259.

In memory interface unit 120, write strobe gate 203 is a tri-state device that has an input coupled to communication path 230 to receive the internal write strobe signal generated by communication logic 130. The tri-state input of write strobe gate 203 can be coupled to a control signal that disables data write gate 209 from sending information over data bus 250. Write strobe gate 203 is coupled at an output to output enable line 256 and to an input of feedback gate 206. Feedback gate 206 is coupled at an output to a tri-state input of data write gate 209. Receiving the output of write strobe gate 203 allows feedback gate 206 to enable and disable the writing of data to external memory unit 110 depending on the signal output from write strobe gate 203.. Feedback gate 206 is a gate that is capable of enabling and disabling N data write gates 209. If N is sufficiently low in other embodiments of the present invention, feedback gate 206 is not necessary and the output of write strobe gate 203 can be fed directly into the tri-state input of data write gate 209.

Data write gate 209 and data read gate 212 make up a bi-directional input/output gate that allows for the transfer of data between memory interface unit 120 and external memory 110 through data bus 250 during data read and data write operations. Data write gate 209 is a tri-state device that, when disabled, allows other gates to control the placement of data on data bus 250. The input of data write gate 209 is coupled to communication path 233 to receive data signals that will be written to external memory 110 from digital logic 130, while the output of data write gate 209 is coupled to data bus 250. Data read gate 212 is coupled at an input to data bus 250 and at an output to communication path 236. Data read over data bus 250 from external memory 110 is sent to digital logic 130 over communication path 236.

Output enable gate 215 and address gate 218 are also tri-state devices that may be coupled at their respective tri-state inputs to allow digital logic 130 to disable the gates from sending information through bus 140. Output enable gate 215 has an input coupled to communication path 239 and an output coupled to output enable line 259. Address gate 218 has an input coupled to communication path 242 and an output coupled to address bus 253.

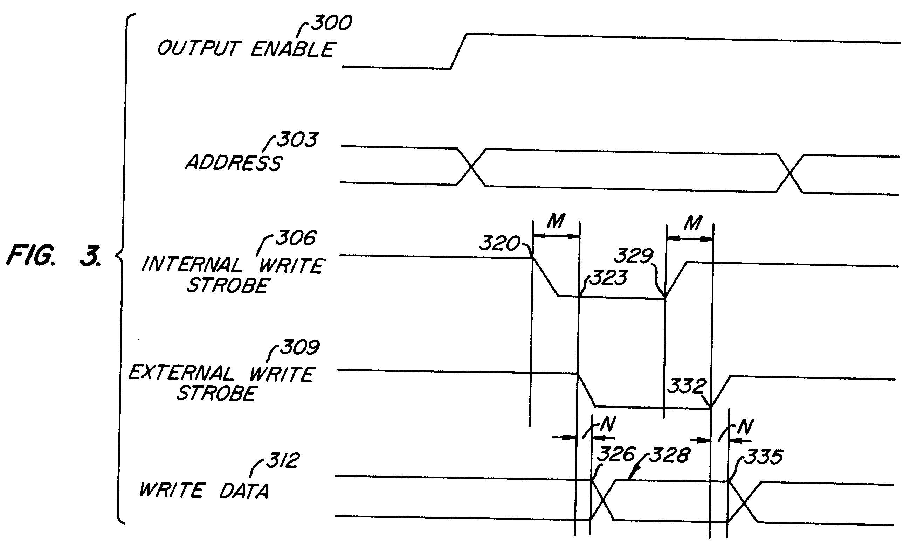

In operation, memory interface unit 120 either writes data from digital logic 130 to external memory 110 or reads data from external memory 110 to digital logic 130. The manner in which data is read from external memory 110 is well known. The manner in which data is written to external memory 110 is discussed below with references to Figs. 2 and 3.

Fig. 3 is a timing diagram that depicts the timing of a write cycle when data is written to external memory 110 from memory interface unit 120 depicted in Fig. 2. The signals depicted in Fig. 3 include an output enable signal 300., an address signal 303, an internal write strobe signal 306, an external write strobe signal 309, and a write data signal 312.

To begin the write cycle, memory interface unit 120 deasserts output enable signal 300, which is normally asserted low, through output enable gate 215 to indicate to external memory 110 that a write operation will take place. The deasserted output enable signal is received at the tri-state input of data output gate 269 and disables data output gate 269 from sending data to data bus 250 by placing it in a high impedance mode. The address at which data will be written is placed on address bus 253 by address gate 218 as indicated by address signal 303.

Digital logic 130 then asserts internal write strobe signal 306 logic low to initiate the write cycle as indicated by 320. As indicated by 323, write strobe gate 203 drives the asserted internal write strobe signal from communication path 230 to write strobe line 256 as external write strobe signal 309. The delay M that occurs between points 320 and 323 is caused by a combination of the internal delay of write strobe gate 203, the capacitance of the load (external memory 110) coupled to write strobe gate 203 through write strobe line 256, and the length of the board traces.

Feedback gate 206 detects the assertion of external write strobe signal 309 and outputs a signal to enable data write gate 209. When data write gate 209 is enabled, data is placed on data bus 250 by write data signal 312 as indicated by 326. The delay N that occurs between 323 and 326 is introduced by the internal gate delay of feedback gate 206 and the response time of enabling/disabling input of data write gate 209. Shortly after data is placed on data bus 250 it becomes stable as indicated by 328.

To complete the write cycle, internal write strobe signal 306 is deasserted starting at 329 by digital logic 130. External write strobe signal is then deasserted at 332 after a delay M due to the capacitance of the load and internal gate delays as described above. After external write strobe signal 309 is deasserted, feedback gate 206 sends a signal to disable data write gate 209 and release data bus 250 for another operation as indicated by 335. The delay N that occurs between 332 and 335 is introduced by the internal gate delay of feedback gate 206 and the response time of enabling/disabling input of data write gate 209.

The release of data bus 250 always occurs after the deassertion of external write strobe signal 332 because external write strobe signal 332 is input to feedback gate 206, which enables and disables data write gate 209. Thus, no matter how much external write strobe signal 309 is delayed because of the capacitive loading of external memory 110, write data signal 312 will remain valid on data bus 250 until after write strobe signal is deasserted. Additionally, if external memory 110 requires a fixed data hold time greater than zero, feedback gate 206 can be coupled with a delay gate to provide the necessary delay time.

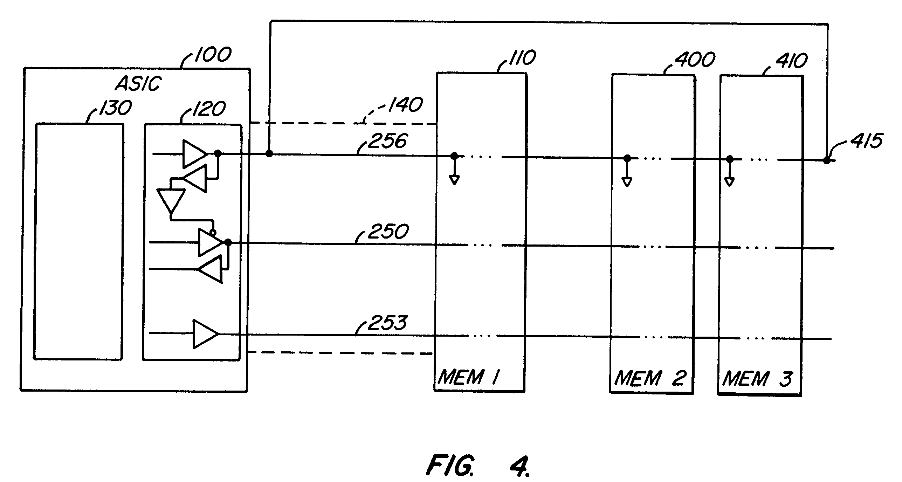

Fig. 4 is a block diagram showing how memory interface unit 120 shown in Fig. 2 can be used to automatically adjust for timing delays inherent when multiple memories are coupled to write strobe line 256. For convenience, the same reference numerals used in Figs. 1 and 2 are used in Fig. 4 to refer to like elements. In Fig. 4, integrated circuit 100 has external memories 110, 400, and 410 coupled to it through write strobe line 256. Attaching external memories 400 and 410 as an additional load on write strobe line 256 adds additional capacitance to the line resulting in a delay in external write strobe signal 309 that is even greater than delay M shown in Fig. 3.

The additional delay does not cause a problem with the timing of the write operation, however, if the input of feedback gate 206 is detached from the output of gate 203 on the ASIC and instead coupled to write strobe line 256 at a point 415 at the end of load 110, 400 and 410. This allows feedback gate to feed external write strobe signal 309 into the tri-state input of data write gate 209 after it has propagated through external memories 110, 400, and 410. Thus, data write gate 209 will be enabled and disabled only after external write strobe signal 309 propagates through external memories 110, 400, and 410.

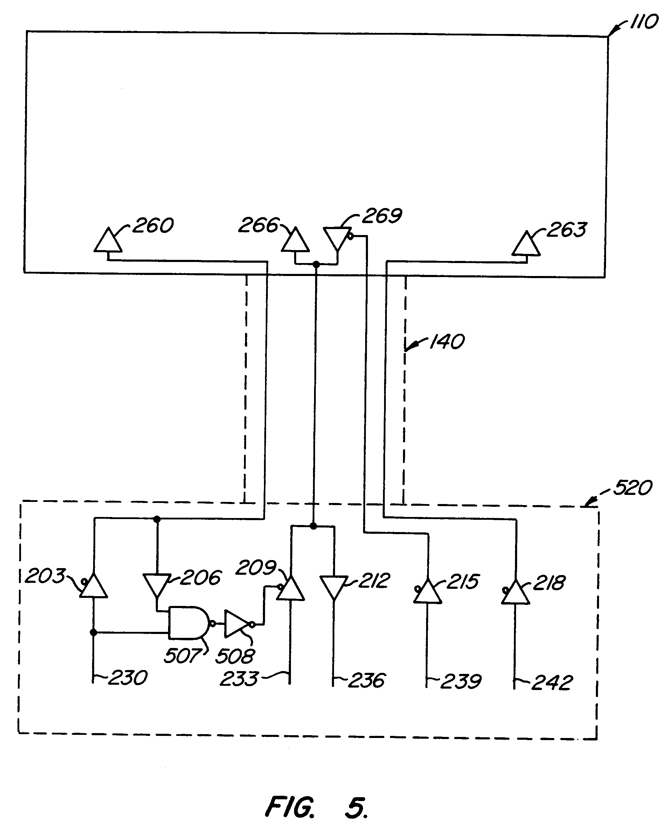

Fig. 5 is a schematic diagram of memory interface unit 520 according to a second embodiment of the present invention. For convenience, the same reference numerals used in Figs. 1 and 2 are used in Fig. 5 to refer to like elements. Furthermore the construction and operation of memory interface unit 520 is identical to that of memory interface 120 except for the addition of gates 507 and 508.

Memory interface unit 520 comprises write strobe gate 203, feedback gate 206, NAND gate 507, inverter 508, data write gate 209, data read gate 212, output enable gate 215, and address gate 218. Communication paths 230, 233, 236, 239, and 242 carry the same signals in memory interface unit 520 as in memory interface unit 120. Additionally, data read gate 212, output enable gate 215, and address gate 218 perform functions identical to the ones they perform in memory interface unit 120.

Just as in memory interface unit 120, write strobe gate 203 is a tri-state device that has an input coupled to communication path 230 to receive the internal write strobe signal generated by communication logic 130. Write strobe gate 203 is coupled at an output to output enable line 256 and to an input of feedback gate 206. The input of write strobe gate 203, however, is also coupled to a first input of NAND gate 507. A second input of NAND gate 507 is coupled to the output of feedback gate 206 which receives the output of write strobe gate 203.

An output of NAND gate 507 is coupled to an input of inverter 508, and an output of inverter 508 is coupled to a tri-state input of data write gate 209. Just as in memory interface unit 120, data write gate 209 is a tri-state device that, when disabled, allows other gates to control the placement of data on data bus 250.

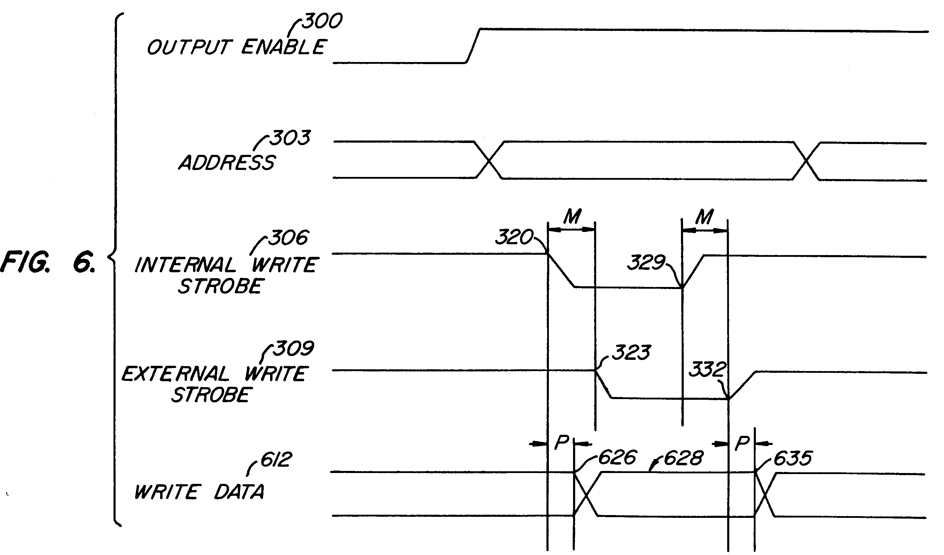

The operation of memory interface unit 520 is identical to the operation of memory interface 120 except for the manner in which the tri-state input gate of data write gate 209 is controlled. The operation of and the manner of enabling/disabling data write gate 209 in this embodiment provides a better data setup time than the embodiment of fig. 2 and is discussed below with references to Figs. 5 and 6.

Fig. 6 is a timing diagram that depicts the timing of a write cycle when data is written to external memory 110 from memory interface unit 520 depicted in Fig. 5. The signals depicted in Fig. 6 include an output enable signal 300, an address signal 303, an internal write strobe signal 306, an external write strobe signal 309, and a write data signal 612.

To begin the write cycle, memory interface unit 520 deasserts output enable signal 300, which is normally asserted low, through output enable gate 215 to indicate to external memory 110 that a write operation will take place. The deasserted output enable signal is received at the tri-state input of data output gate 269 and disables data output gate 269 from sending data to data bus 250 by placing it in a high impedance mode. The address at which data will be written is placed on address bus 253 by address gate 218 as indicated by address signal 303.

Digital logic 130 then asserts internal write strobe signal 306 logic low to initiate the write cycle as indicated by 320. When internal write strobe signal 306 goes low, the input to NAND gate 507, is low which forces the output of NAND gate 507 to be high and the output of inverter 508 to be low. The low output of inverter 508 then enables data write gate 209. When data write gate 209 is enabled, data is placed on data bus 250 by write data signal 312 as indicated by 626.

Data is made stable in the embodiment of fig. 5 by the assertion of the internal write strobe signal rather than the assertion of the external write strobe signal. Thus, data is valid earlier than the embodiment of fig. 2, which results in a better data setup time for a data write. The delay P that occurs between 320 and 626 is introduced by the internal gate delay of NAND gate 507, inverter 508, and the response time of enabling/disabling input of data write gate 209. Shortly after data is placed on data bus 250 it becomes stable as indicated by 628.

As indicated by 323, write strobe gate 203 drives asserted internal write strobe signal 306 from communication path 230 to write strobe line 256 as external write strobe signal 309. The delay M that occurs between points 320 and 323 is caused by a combination of the internal delay of write strobe gate 203, the capacitance of the load (external memory 110) coupled to write strobe gate 203 through write strobe line 256, and the length of the board traces.

To complete the write cycle, internal write strobe signal is deasserted starting at 329 by digital logic 130. External write strobe signal is then deasserted at 332 after a delay M due to the capacitance of the load and internal gate delays as described above. After external write strobe signal 309 is deasserted, both inputs to NAND gate 507 are high, which forces the output of NAND gate 507 to be low. The output of inverter 508 is then high, which disables data write gate 209 and releases data bus 250 for another operation as indicated by 635. The delay P that occurs between 332 and 635 is introduced by the internal delay of NAND gate 206, gate 507, inverter 508, and the response time of enabling/disabling input of data write gate 209 as discussed above.

The logic of NAND gate 507 and inverter 508 always insures that data bus 250 is released by data write gate 209 after the deassertion of external write strobe signal 332. Thus, no matter how much external write strobe signal 309 is delayed because of the capacitive loading of external memory 110, write data signal 312 will remain valid on data bus 250 until after external write strobe signal 309 is deasserted. Additionally, if external memory 110 requires a fixed data hold time greater than zero, gates can added to provide the necessary delay time.

Having fully described the preferred embodiments of the present invention, many other equivalent or alternative methods of implementing system for providing data hold time during write operations to SRAMs will be apparent to those skilled in the art. For example, it is possible to use a separate input receiver for feedback gate 206 in figs. 2 and 5. The separate input receiver would then be coupled to the write strobe line of the load at a point external to memory interface unit 120. These equivalents and alternatives are intended to be included within the scope of the present invention.

## Claims

1. A semiconductor integrated circuit for interfacing to a memory unit that, for a data write operation to be successful, requires data to be held on a data bus until a write strobe signal sent to the memory unit from said semiconductor integrated circuit over a transmission channel is deasserted, said semiconductor integrated circuit comprising:
(a) writing means, coupled to the data bus at an output, for placing data on the data bus so that said data can be written to the memory unit, said writing means having a control input to accept a control signal that enables and disables the placement of said data on the data bus; and
(b) disabling means, coupled at an input to the transmission channel to receive the write strobe signal fed back from the memory unit and coupled at an output to said control input of said writing means, for disabling said writing means upon deassertion of the write strobe signal.

2. The semiconductor integrated circuit of claim 1, wherein said writing means comprises a tri-state buffer and said control input is a tri-state input.

3. The semiconductor integrated circuit of claim 1 wherein said disabling means comprises a buffer gate.

4. The semiconductor integrated circuit of claim 1 wherein said disabling means is further coupled to a disabling input receiver coupled to an input pin.

5. The semiconductor integrated circuit of claim 1 further comprising:
(a) reading means, coupled to said writing means, for reading data placed on the data bus by the memory unit;
(b) an output enable gate, coupled to the transmission channel, for sending an output enable signal over the transmission channel to the memory unit;
(c) an address gate, coupled to the transmission channel, for sending an address to the memory unit.

6. The semiconductor integrated circuit of claim 5 wherein:
said writing means comprises a tri-state buffer and said control input is a tri-state input;
said output enable gate comprises a tri-state buffer; and
said address gate comprises a tri-state buffer.

7. A semiconductor integrated circuit for interfacing to a memory unit that, for a data write operation to be successful, requires data to be placed on a data bus after the assertion of a write strobe signal sent to the memory unit from said semiconductor integrated circuit over a transmission channel and requires the data to be held on the data bus until the write strobe signal is deasserted, said semiconductor integrated circuit comprising:
(a) writing means, coupled to the data bus at an output, for placing data on the data bus so that said data can be written to the memory unit, said writing means having a control input to accept a control signal that enables and disables the placement of said data on the data bus;
(b) transmitting means, coupled at an output to the tranmsission channel, for transmitting the write strobe signal received at an input to the memory unit over the transmission channel; and
(c) disabling means, coupled at a first input to the transmission channel to receive the write strobe signal fed back from the memory unit and coupled at an output to said control input of said writing means, for enabling said writing means upon assertion of said write strobe signal and for disabling said writing means upon deassertion of said external write strobe signal.

8. The semiconductor integrated circuit of claim 7, wherein said disabling means is further coupled at a second input to said input of said transmitting means.

9. A method of providing a minimum data hold time for a memory during a write operation, comprising the steps of:
(a) asserting an external write strobe signal to initiate the write operation;
(b) enabling a data write gate to output data to a transmission channel;
(c) deasserting said external write strobe signal;
(d) disabling said data write gate with the deassertion of said external write strobe signal so that said data write gate is disconnected from said transmission channel.

10. The method of providing a minimum data hold time as set forth in claim 9, wherein said data write gate is enabled by the assertion of said external write strobe signal.
